# EUROPEAN PATENT APPLICATION

(11) **EP 3 361 400 A1**
(43) Date of publication of application: **15.08.2018**
(21) Application number: 18155680.4
(22) Date of filing: 08.02.2018
(51) Int. Cl.: G06F 17/50, A61G 5/10

(54) **METHOD AND ELEMENT FOR DETERMINING THE SHAPE FOR A CUSTOM-MADE SEAT SHELL**

(30) Priority: 09.02.2017 BE 1705086
(71) Applicant: Vigo NV, 9230 Wetteren (BE)
(72) Inventor: Vermandel, Miguel, 9230 Wetteren (BE)
(74) Representative: Brantsandpatents bvba

(57) **Abstract**

In a first aspect, the invention relates to a method for designing a personalized shell seat for a subject, the method comprising obtaining a two-dimensional sagittal profile of the seating surface of a seating device, in which the shape of the seating surface is adapted to the posture and/or body contours of a subject sitting onto the seating device, and the computer-controlled design of a three-dimensional shell seat model, at least based on said obtained two-dimensional profile. In a second aspect, the invention relates a computer-controlled program for designing a personalised shell seat for a subject, for supporting the method and in a third aspect, the invention relates to a personalised shell seat for a subject that is designed using the method.

## Description

### TECHNICAL DOMAIN

The present invention relates to a method for custom-making a shell set for supporting a person. The invention also relates to an element for realizing the method, a computer-controlled program for supporting the method and a shell seat, fabricated based on the information obtained by the method.

### STATE OF THE ART

Such a method is well-known in the practice. Persons with an anomaly or a disease of the support or musculoskeletal system can get a custom-made shell seat if they have such an anomaly that they can for example not sit in a standard adjustable seat. Persons with a handicap can also suffer from pressure spots, resulting in decubitus. Also for them, a custom-made shell seat can offer a solution. For these person, a so-called seat orthosis can be custom-made.

Individual custom-made shell seats (Dorsolumbofemoral seat orthoses) constitute an important product group within the domain of technical orthopaedics. In a common method, the correct shape of the orthosis is obtained by taking a print of the person or of the part of the body by means of a vacuum bag. Such a vacuum bag can be filled with polystyrene granules and takes the shape of the person or of the part of the body of the person when that person takes a seat in the vacuum bag. Subsequently, the vacuum bag is fixed by sucking the air that is present in the vacuum bag, out of the bag. The patient is then later positioned correctly by adjusting the shape of the vacuum bag while the patient sits in the vacuum bag. A problem is that this way of working is difficult (hence, the patient is in the way to adjust the vacuum bag under the patient), is not unambiguous and does not allow for an objective evaluation of the seating position that is obtained. A problem is that the positioning is based on the experience of the person carrying out the measurements and can only be realized by high-specialized persons. Based on the vacuum shape that is obtained in this way, a digital image can be created by either directly scanning the outlines of the vacuum shape in a digital way or first plastering the vacuum bag and subsequently scanning the resulting plaster in a digital way.

Both the shape, obtained by means of the vacuum bag and the shape, obtained by means of the plaster print, cannot be used directly for the final modelling of the shell seat. Corrections still have to be made, so that a shell seat mould is obtained that offers sufficient support and that is comfortable. A problem is that these corrections are often made by another person than the person carrying out the measurements and that this is a subjective process. In order to make these corrections, additional separate measurements are often taken. A problem is that mostly, a unambiguous definition of these additional measurements is not possible and that they can be interpreted freely.

Based on this digital image, a milling machine can be controlled, milling a seat orthosis out of a block of foam or milling a mould out of a block of foam onto which a seat orthosis is thermoformed.

WO 2014 146 157 A1 describes an alternative method for custom-making a support apparatus such as a shell seat. For determining the desired shape for the support apparatus, the relevant part of the body of the subject is brought into a "supported position", within a flexible supporting sheet. In this position, the three-dimensional shape of the subject is subsequently measured by means of a scanner, along the outer side of the supporting sheet.
US 2010 268 138 A1 also describes such a method, in which the shape to obtain for the supporting apparatus is reconstituted from a plurality of images of the subject, from different angles. Thereto, the subject is previously provided with visual reference points.

Finally, EP 1 980 224 A2 describes a system for scanning and visualizing a three-dimensional anatomic model for a subject. This model can be further refined, by means of additional information. Based on this refined model, an orthopaedic apparatus can finally be fabricated for the subject.

Often, there are different intermediate models for the shell seat, to each of which corrections are made, each time after fitting a semi-finished shell seat. As a result, this method is expensive and time-consuming. Both the price of the final product and its delivery time, increase. Moreover, such additional corrections are mostly not unambiguous, but they are based on the experience of the person measuring the corrections and the person adjusting the shell seat. As a result of this subjective measuring process and the subsequent corrections, the final result is mostly only suboptimal. An additional problem is that the resulting shell seat is big, bulky and that it can often be stigmatising for the patient.

The present invention aims to find a solution for at least some of the above-mentioned problems.

### SUMMARY OF THE INVENTION

In a first aspect, the invention relates to a method for determining the shape of a custom-made shell seat for a subject according to claim 1. For 70% of the people requiring such a shell sat, the asymmetry is quite limited. As a result, the shape of the shell seat is largely determined by its two-dimensional, sagittal cross-section. Further measurements can be taken by means of other measurement instruments such as tape measures or coordinates on a mat. Some measurements can even simply be taken from databases for 'average subjects'. An advantage of this method, in which the most fundamental dimension and/or shape determination relates to the determination of the 2D sagittal profile of the subject, is that a device can be made that simplifies the positioning of the subject, makes it unambiguous and allows to evaluate the positioning in an objective way compared to a method in which the complete 3D shape of the seat and back of the subject is measured, by means of means such as a plaster mould or a vacuum bag. A second advantage of the method is that, by moreover using a computer-controlled program, it can use the computing force of an electronic apparatus, as a result of which, with a minimum of measurement values and shapes, an optimal shell seat shape can still be computed. In a second aspect, the invention relates to a computer-controlled program for designing a personalized shell seat of a subject according to claim 12. This computer-controlled program has the advantage that it supports, accelerates, automatizes and objectifies the method. This allows to obtain the optimal shell seat shape based on a minimum of measurement values and shapes. In a third aspect, the invention relates to a personalized shell seat for a subject according to claim 15. The advantage of this shell seat is that a minimalistic shape is obtained in which the necessary support can still be guaranteed, the shell seat is less stigmatizing and with only a minimum of discomfort for the subject.

### DESCRIPTION OF THE FIGURES

**Figure 1a** shows an embodiment of the seat device in three-dimensional perspective, in which the seat device is provided with a semi-flexible element.
**Figure 1b** is a detailed illustration of a support provided at the seat device, appropriate for providing support at the inner side of the upper legs.
**Figure 2a** shows an exploded view of the semi-flexible element, according to a possible embodiment.
**Figure 2b** shows a three-dimensional perspective of an embodiment of the semi-flexible element.
**Figure 2c** shows a detail of an embodiment of the semi-flexible element and the printing pattern provided thereto.
**Figures 3a****-d** show an embodiment of a part of the method, in which the seating surface of the shell seat is modelled based on the sagittal profile, a number of measurement points and a database with transverse cross-sections of the back and the seat of subjects.
**Figure 4a** shows an exploded view of the modular shell seat, according to an embodiment of the invention.
**Figure 4b** shows an embodiment of a shell seat, that has been milled monolithically out of foam.

### DETAILED DESCRIPTION

The present invention relates to a method for custom-making a shell set for supporting a person. The invention also relates to an element for realizing the method.
Unless otherwise specified, all terms used in the description of the invention, including technical and scientific terms, shall have the meaning as they are generally understood by the worker in the technical field of the invention. For a better understanding of the description of the invention, the following terms are explained specifically.

The "trochanter major" or large trochanter is a bone structure that is part of the thigh-bone. The trochanter major is located at the top (proximal) at the outer side (lateral) of the thigh-bone shaft, at the position where the thigh-bone neck is located at the inner side (medial). At most subjects, the trochanter major can be used as a reference point for the measurement, because it is easy to scan, and also, to palpate. The position of the trochanter is one of the anatomically important points that should be determined for establishing the profile of a patient.

"Lordosis" is the natural curvature of the spine in the forward and backward direction. With a lordosis, the convex side of the spine is directed forward. Lordoses are found in the cervical and lumbal spine. With a strong lordosis in the lumbar region, we speak of a "hollow back". The counterpart of lordosis, with the convex side of the spline to the back, is indicated by the term "kyphosis". "Scoliosis" is an unnatural curvature of the spine in the lateral direction.

The term "sagittal" is an indication of an anatomical plane, named after the arrow seam, extending from the front to the back over the skull. Hence, the sagittal plane extends from the front to the back, and divides the body of a standing subject (or subject sitting straight or leaning backwards) into a left and a right half. A sagittal direction is a direction that is enclosed by the sagittal plane. Structures close to the sagittal plane are also called "medial". The term "substantially sagittal direction" refers to a direction essentially approaching the sagittal direction. This substantially sagittal direction is preferably completely enclosed by the sagittal plane, but it can show aberrations with respect to this sagittal plane. These aberrations amount to less than 10%, preferably less than 5%, more preferably less than 2%, still more preferably less than 1%. The sagittal plane of a subject sitting onto a seating device (thereby sitting straight or leaning backward) can be understood as linked to the subject, but also as linked to the seating device. Of course, both sagittal planes coincide, so that the term is well defined. Planes extending parallel to the sagittal plane, wherever in the body, are called "parasagittal planes". Other important planes related to the human anatomy, are the "transverse planes". A transverse plane is always situated horizontally for a straight-standing subject, and divides his/her body into a lower and an upper part. For a subject that is sitting straight, these planes should be seen as linked to the body in a fixed way. The transverse planes at the thigh-bone will hence for example be essentially in a vertical plane.

In a first aspect, the invention relates to a method for designing a personalized shell seat for a subject, the method comprising obtaining a two-dimensional sagittal profile of the seating surface of a seating device, in which the shape of the seating surface is adapted to the posture and/or body contours of a subject sitting onto the seating device, and the computer-controlled design of a three-dimensional shell seat model, at least based on said obtained two-dimensional profile.

The dependent setting of the seating device to the posture and body contours of a seated subject is essential for obtaining a shell seat for these often asymmetric patients. The adjustability of the seating device to the shape of the person contributes to the obtained seating comfort of the intended shell seat. When adjusting the seating device, a patient gets a truthful feeling of the seating comfort of the shell seat. Moreover, by mechanically switching at the seating device, a care provider can also make sure sufficient support is provided at essential positions. Hereby, the care provider feels how much pressure is necessary when mechanically adjusting, which is a further advantage of the method. When measuring, it is no longer the measurements of the patients that are taken, contrary to methods of the state of the art, but it is the shape of the finally desired end product, i.e. the custom-made shell seat, that is determined.

For 70% of the people requiring such a shell sat, the asymmetry is quite limited. As a result, the shape of the shell seat is largely determined by its two-dimensional, sagittal cross-section. Further measurements can be taken by means of other measurement instruments such as tape measures or coordinates on a mat. Some measurements can even simply be taken from databases for 'average subjects'. An advantage of this method, in which the most fundamental dimension and/or shape determination relates to the determination of the 2D sagittal profile of the subject, is that a device can be made that simplifies the positioning of the subject, makes it unambiguous and allows to evaluate the positioning in an objective way compared to a method in which the complete 3D shape of the seat and back of the subject is measured, by means of means such as a plaster mould or a vacuum bag. A second advantage of the method is that, by moreover using a computer-controlled program, it can use the computing force of an electronic apparatus, as a result of which, with a minimum of measurement values and shapes, an optimal shell seat shape can still be computed. A further advantage is that a measurement device can be made in which the final positioning of the subject can be evaluated by the caregiver (e.g. occupational therapist) prior to the fabrication of the shell seat. As a result, no further measurement sessions are necessary (the measurement is the first fit), drastically reducing the delivery time of the shell seat. This leads to a considerable saving in working and production costs.

Obtaining the sagittal profile of a person is essential for obtaining a shell seat model, since this profile constitutes the base of the shape characteristics of a shell seat. The method is mainly oriented to designing shells seats for symmetric subjects or subjects with a moderate asymmetry, mainly situated in the lower part of the body. Hence, the method is applicable to the majority (namely 70%) of the persons requiring a shell seat. In order to design a shell seat for a strongly asymmetric subject, or a subject with moderate asymmetric upper part of the body (for example subjects with scoliosis), 3D techniques should be used such as a plaster mould or the vacuum bag. The two-dimensional sagittal profile, combined with a number of discrete measurement values and possibly shapes from a database, are not sufficient for determining the optimal shape.

According to a preferred embodiment of the method, the seating surface of the seating device is realized by means of a thin, semi-flexible, rectangular element, that is rigid in its width direction and flexible in its longitudinal direction, in which the element is bent according to the longitudinal direction to a conventional seating surface, adapted to the posture and/or the body contours of the subject. A conventional seating surface should thereby be seen as a seating surface that substantially corresponds to that of a seating or reclining chair, with a substantially flat seat and a substantially flat back support, constituting a right or obtuse angle with respect to each other. The seating surface is however adapted to the subject, in that sense that it follows the sagittal curvature of amongst other things the legs, the bottom and the back, in a continuous line. The width direction of the element is hereby always oriented to what one would call the width direction of the conventional seating surface, and is thus perpendicular to the sagittal plane of the seating surface.

A first advantage is that the person can take a seat on a conventional seating surface, of which the seat and the back support are realized through the semi-flexible element. As a result, the discomfort of the subject is minimal and it facilitates the positioning by the measuring person, contrary to the measurement methods making use of for example plaster moulds or vacuum bags. Preferably, additional elements are also provided, such as armrests, a head rest, side supports at the shoulders and/or a side support at the inner side of the upper legs (a bobbin). The advantage thereof is that the subject can better imagine how the actual shell seat will feel at the body and the caregiver (occupational therapist) can evaluate the corrected seating position before the shell seat is actually fabricated.

This clearly contrasts with the method according to WO 214.146.157 A1, in which the subject is only supported by a flexible supporting sheet, which supporting sheet does not have any correcting function. For the final shell seat, the exact shape of the subject is simply taken. Such shell seats typically fit too tight. This mould also hardly never describes the most desired, ideally correcting and/or supporting shape of the shell seat.

The present invention provides for a method in which at least a part of the data that have been collected (e.g. the 2D sagittal profile) does no longer directly relate to the body of the subject, but rather to the inner side of the shell seat to fabricate. Thereby, the measured values, and in particular the two-dimensional, sagittal profile still only have to be corrected minimally or not at all.
A second advantage of the specific characteristics of the element is that all 2D parasagittal profiles of the seating surface are equal to each other and to the 2D sagittal profile of the seating surface. According to a preferred embodiment of the method, the element has a rectangular shape, and its side is accessible from at least one side. The sagittal profile of the seating surface is then equal to the parasagittal profile of the seating surface at that side, and can thus be easily measured.

According to a preferred embodiment of the invention, the profile is generated by means of digitally detectable reference points, provided at the seating device. The advantage is that the element can be scanned digitally, after which its shape an dimensions can be read and processed by a computer-controlled program at an electronic apparatus. The advantage of the use of digitally detectable reference points is that they allow a much more accurate determination of the shape and/or dimensions of the element.

According to a further preferred embodiment, a digital image of the seating device that has been adjusted to the subject provided with reference points is obtained, and that image is imported into a computer-controlled program, after which the profile is generated by said program. More preferably, a photograph of the element is taken from the (accessible) side. The parasagittal profile of the seating surface on the element, from this side, can thereby automatically be taken from this photograph by a computer-controlled program, both as to the shape and as to the dimensions. According to a non-limiting preferred embodiment of the method, the element is rectangular. At its (accessible) side, it is provided with a clear, digitally detectable colour shading. A photograph is then taken of the seating device, from its (accessible) side. The digitally detectable reference points are provided at the seating device, on its frame: they have a fixed position with respect to each other and with respect to the frame, and they are not integrated in the element. Moreover, they are provided in the (parasagittal) plane of the respective side. It is about a type of fiducial marks: all distances in the respective plane can be calculated from the photograph and a number of data (surface, spacing and positioning with respect to each other) of the marks. Preferably, a digital photograph is taken by means of an electronic apparatus, and this photograph is subsequently processed by means of the same electronic apparatus. More preferably, a tablet is used therefore. A computer-controlled program, loaded on the tablet, applies a perspective transformation to the photograph. It transforms the photograph to a frontal image at the side of the seating device, at least relating to the parasagittal plane at the side of the element. Possibly, the transformed photograph is furthermore turned into black and white, a "bilateral filtering" and/or "adaptive thresholding" is applied, so that the shape an dimensions of the sagittal profile of the seating surface can finally be further derived.

According to a preferred embodiment of the invention, additional parameters are entered into the computer-controlled program, in which the parameters are linked to anatomic dimensions of the subject.

According to a preferred embodiment of the invention, additional anatomic dimensions are read by entering coordinates, read from a printed raster on the element. A computer-controlled program calculates the corresponding dimensions from these coordinates, taking into account the curvature of the element.

The advantage is that a better shell seat model can be assembled, based on the sagittal profile of the seating surface on the one hand, and based on said parameters on the other hand. The length and/or width of one or more parts of the body of the person are for example measured. According to a non-limiting example, the position of the trochanter major is first determined by means of palpating. An imaginary, oblique 2D parasagittal coordinate system is drawn up, with an axis essentially following the thigh-bone and an axis directed to the armpits. Along these axes, the central position of amongst other things the shoulders, the armpits, the waist and the knees is measured. Furthermore, at least the width at the armpits, the waist, the trochanter major and the knees is measured. All distances are entered in the program, that is preferably loaded onto a tablet. The nature of the dimensions should be such that the modelled seating surface is optimal, while their number is minimal. All these dimensions, as well as the way in which they have to be measured, are fixed. The advantage is that the modelling of a shell seat is reduced to a deterministic and objective process, requiring less fitting sessions and corrections.

According to a further preferred embodiment, at least a part of said parameters is linked to the profile. The profile is then positioned and oriented in the modelling space, with respect to the measured points.

According to a preferred embodiment of the invention, the three-dimensional shell seat model is at least designed based on the two-dimensional profile, the additional parameters and a database with one or more, two-dimensional, transverse profiles of the seating surface of personalized shell seats. The advantage is that the optimal shell seat is modelled based on a modellable element and a minimum of measurements, for which a device can be made that facilitates the positioning of the subject, makes it unambiguous and allows to evaluate the positioning in an objective way. A second advantage is that the modelling is based on data that had been collected previously. In this way, the knowledge that had already been acquired, is integrated automatically in the development of new shell seats. According to a non-limiting example, the design of the shell seat is made by means of a computer-assisted designing program such as a CAD model. In particular, the three-dimensional model for the seating surface is thereby generated based on the two-dimensional, sagittal profile. Thereby, the points respectively enclosing the shoulder, xyfoid, the armpits, the waist, the trochanter major, the knees and similar at the left and right side, are determined. They are linked with the sagittal profile to a meshed surface in the three-dimensional space, by means of the scaled, transverse profiles from the database (also called "spline functions"). This meshed surface serves as a model for the seating surface. With this development, special attention is paid to the G2 continuity of the model.

According to a preferred embodiment of the invention, the element comprises elongated, rigid parts, extending over the width direction of the element. The advantage is that these parts ensure the rigidity of the element in its width direction, without hindering the flexibility of the element according to its longitudinal direction. According to a non-limiting example, the element is provided internally with parallel rods that end in digitally detectable end points. Preferably, the element is placed onto the seating device, so that the parallel rods are oriented according to the width direction of the chair, with the digitally detectable end points accessible at the side (for example for taking photographs).

According to a further preferred embodiment of the invention, said rigid parts comprise plywood or multiply. The advantage is that plywood/multiply is robust, but has a low production cost and a low specific gravity. According to a non-limiting example, the element comprises parallel strips of plywood, in the plane of the element.

According to a preferred embodiment of the invention, the flexural rigidity of the element, associated with the flexure of the element along its width direction, is situated between 0,2 M/mm² and 40 N/mm². This value is preferably defined by establishing a possible measurement experiment: first of all, the element, as far as it is not yet the case, is released from the seating device. Subsequently, the element is placed in a horizontal direction onto two beams, respectively supporting the left and the right part of the element, of the complete length of the element. Preferably, each of both beams comprises a steel, U-shaped profile, that is shifted at the left and right side over the side parts of the thin element. The U-shaped profiles thereby comprise two legs with a length between 10 mm and 30 mm. The width of the U-shaped opening is preferably equal to or slightly larger than the thickness of the element. Subsequently, the element is loaded centrally, over its complete length, with a homogeneous, linear power density (in Newton per meter of distance according to the length of the element). The linear power density amounts to minimally 100 N/m and at the most 1200 N/m. More preferably, this linear power density is realized by applying, in a supportive way, a metal rod, centrally onto the element and oriented according to the length direction of the element, in which the rod and the element essentially have the same length. By means of a non-limiting example, the rod and the element have a length of 1,5 m, the rod is made of stainless steel and it has a mass of 50 kg. The maximum flexure of the element under load is now measured. The flexural rigidity of the element, associated with the flexure of the element according to the width direction, is now the ratio of the linear power density to this maximum flexure. All distances are preferably expressed in mm. It should be noted that the test does not necessarily have to be carried out over the complete length of the element. The test is for example applied to a strip with a length of at least 30 cm that has been cut out of the element, and that extends over the width of the element. In particular, the test can be applied to such strips that moreover essentially coincide with the seat and/or the back support of the seating device, when the element would be attached in a removable way to the seating device and would be adapted to the posture and/or body contours of a subject that sits onto the seating device. The relevant length is in this case the length of this strip of the element.

The element thus has a minimal flexural rigidity of 0,2 N/mm², associated with its flexure according to the width direction. This has the advantage that the parasagittal profile of the element, as it is measured at the side (preferably by means of a digital image), corresponds to a very large extend to the sagittal profile, centrally onto the seating device. This is even the case when the subject sits onto the seating device: this minimal rigidity guarantees that the central flexure is minimal.

According to a preferred embodiment of the invention, the element can be bent elastically according to its length direction, with a maximum curvature of at least 0,025 mm⁻¹. The maximum curvature for elastic flexures that can be obtained, should not be larger than 0,1 mm⁻¹, since the sagittal profile of the seating surface can then already be approached with sufficient accuracy. Preferably, the maximum curvature for elastic flexures in the length direction that can be obtained is approximately equal to 0,025 mm⁻¹. The advantage is that the element can be bent sufficiently in its longitudinal direction to describe the sagittal profile of the seating surface, adapted to the posture/body contours of the subject that sits onto it. An additional advantage of such an element is that these flexures always extend in a continuous way.

According to a preferred embodiment of the invention, the element comprises one or more elongated, elastically deformable parts, extending over a part of or the complete longitudinal direction of the element. The advantage of such parts that they connect the rigid parts, extending in the width direction, to each other, so that the element is composed of one element and can be handled easier.

According to a further preferred embodiment of the invention, said elastically deformable parts comprise spring steel. More preferably, the element comprises spring-steel bands, extending over the length of the element, in the plane of the element. The advantage is that the element also has a minimal flexural rigidity in the longitudinal direction, ensuring that the element is easier to handle. This flexural rigidity should however not be too large, so that the element can easily be bent according to the longitudinal direction, as described above. Another advantage of spring-steel bands is that they are difficult to stretch, so that the element is not or little elastic in the longitudinal direction. This ensures unambiguity of the measurements.

Preferably, in its flat position, the element essentially takes a thin, rectangular volume, with an equal thickness, length and width. Thereby, the longitudinal direction is the flexible direction and the width direction is the rigid direction as described above. The elasticity of the element, for stretching or pushing-in the mat in the longitudinal direction or width direction, is preferably negligible. The element has a length between 30 cm and 200 cm, more preferably between 50 cm and 180 cm and still more preferably, the element has a length of about 150 cm. The element has a width between 20 cm and 100 cm, more preferably between 30 cm and 80 cm and still more preferably, the element has a width of about 60 cm. The element has a thickness between 3 mm and 40 mm, more preferably between 5 mm and 30 mm and still more preferably, the element has a thickness of about 10 mm.

According to a preferred embodiment of the invention, the seating device comprises a frame with one or more attachment points, in which the element is retained in the attachment points in a removable way and in which the position of the attachment points with respect to the frame can be set.

An advantage is that the element can take a forced shape at particular positions, that does not necessarily correspond to the posture and/or body contours of the subject. These "forced" manipulations are preferably realized by an occupational therapist or by an experience operator of the seating device who can thus position the patient.

Another advantage is that the element can be replaced by another element. According to a non-limiting example, elements with adjusted rigidity are brought into the seating device, depending on the weight of the subject.

According to a preferred embodiment of the invention, an element of which the shape can be adjusted, is also called a bobbin that is placed between the legs. This bobbin has a specific elasticity and can therefore bend only in 1 direction. In a preferred embodiment, the bobbin is composed of rigid, inflexible rods, delimited at one side by an elastic material and delimited at the other side by a inelastic material. In a preferred embodiment, in the longitudinal direction, a rigid element such as a steel spring is added to guarantee a particular maximum curvature. The advantage of placing such a bobbin is that the patient can be better positioned and that the medical staff can better estimate the effect of the bobbin before actually fabricating the shell seat. Moreover, the presence of the bobbin facilitates the measurement of certain dimensions, such as e.g. knee thickness.
According to a preferred embodiment of the method, based on a digital impression of the modelled shell seat, one or more outer characteristics of the modelled shell seat are modified.

An advantage is that also the outer characteristics of the seating device can be personalized, according to the taste of the subject himself. According to a non-limiting example, after each intervention, the computer-controlled program generates a new impression of the shell seat, which is shown to the subject. The subject can then himself take decisions as to the outer characteristics. The subject can for example decide to change the colour, stitches, the shape of the head rest in the shell seat model. Hence, an optimized shell seat model is obtained, in only one single interview with the subject. The delivery time for the final shell seat will thus be drastically reduced.

In a second aspect, the invention relates to a computer-controlled program for designing a personalized shell seat for a subject. In particular, the input of the program comprises a digital image of a seating device, in which the seating device is adapted to the desired posture and/or body contours of the subject. According to a preferred embodiment of the invention, the input of the program comprises moreover one or more parameters, linked to anatomic dimensions of the subject, and a database, with one or more transverse cross-sections of the seat and/or back of subjects.

The advantage is that the computer program can be used for supporting the above-described method, in which a subject can be positioned correctly in a simple, unambiguous and feasible way for the patient and the measuring person. Indeed, only the two-dimensional, sagittal profile of the seating surface, combined with a number of dimensions, should be measured, instead of the complete, three-dimensional shape. Moreover, the measurement of the sagittal profile doesn't take much time: after adjusting the element, only a (digital) photograph should be taken and a limited number of dimensions should be noted down.

According to a preferred embodiment of the invention, the program validates at least a part of the input based on validation rules. This has the advantage that incorrect measurements can be detected and remediated immediately. Hence, an optimized shell seat model is obtained, in only one single interview with the subject. The delivery time for the final shell seat will thus be drastically reduced.

According to a preferred embodiment of the invention, the program generates a digital impression of the modelled shell seat. An advantage is that also the outer characteristics of the seating device can be personalized, according to the taste of the subject himself. These adaptations can moreover be estimated optimally based on the impression. According to a non-limiting example, after each intervention, the computer-controlled program generates a new impression of the shell seat, which is shown to the subject and the medical staff (occupational therapist).

According to a preferred embodiment of the invention, the computer-controlled program is appropriate for application in the method of one of the claims 1 to 15. Hence, when realizing the method, use can be made of a computer-controlled program. The computing force of the electronic apparatus is thereby used, as a result of which with a minimum of measurement values and shapes, an optimal shell seat mould can be computed. Moreover, the computer-controlled program can guide the (possibly inexperienced) operator of the seating device through the correct positioning of the subject. This is possible because the measurement and positioning process is unambiguous.

In a third aspect, the invention relates to a personalized shell seat for a subject. In particular, the shell seat is modelled based on a two-dimensional, sagittal cross-section of the seating surface, adapted to the subject that sits onto it.

The advantage is that the shell seat can be modelled by means of the above-described method, in which the patient can be better positioned and the final positioning of the subject can be evaluated prior to the fabrication of the shell seat.

An additional advantage is that the shell seat can be modelled based on the above-described method so that it contains the necessary support and enclosure, but is still minimalistic, improving both the user comfort (sweating) and the appearance (less stigmatising).

According to a preferred embodiment of the invention, the shell seat is modular. More preferably, the positions of the separate modules can be further adjusted. The advantage is that this allows a better adjustment of the shell seat. Some of the modules are more preferably standard modules (for example available in three sizes: small-medium-large). According to a non-limiting example, the head rest is available in five sizes.

According to an alternative preferred embodiment, the shell seat is monolithic. The modelled seating surface is then milled out of a large block of foam. The advantage of such shell seats is the very low cost.

According to a preferred embodiment of the invention, the shell seat is modelled, using the method of one of the claims 1 to 15.

Thus, the invention can be described based on the following embodiments:
1. A method for designing a personalized shell seat for a subject, the method comprising obtaining a two-dimensional sagittal profile of the seating surface of a seating device, in which the shape of the seating surface is adapted to the posture and/or body contours of a subject sitting onto the seating device, and the computer-controlled design of a three-dimensional shell seat model, at least based on said obtained two-dimensional profile.
2. The method of the previous embodiment 1, **characterised in that** the seating surface of the seating device is realized by means of a thin, semi-flexible, rectangular element, that is rigid in its width direction and flexible in its longitudinal direction, in which the element is bent according to the longitudinal direction to a conventional seating surface, that is adapted to the posture and/or the body contours of the subject.
3. The method of any one of the previous embodiments, **characterised in that** the profile is generated by means of digitally detectable reference points provided at the seating device.
4. The method of the previous embodiment 3, **characterised in that** a digital image of the seating device that has been adjusted to the subject provided with reference points is obtained, and is entered in a computer-controlled program, after which the profile is generated by said program.
5. The method of any one of the previous embodiments, **characterised in that** additional parameters are entered in the computer-controlled program, in which the parameters are linked to anatomic dimensions of the subject.
6. The method of the previous embodiment 5, **characterised in that** at least a part of said parameters is linked to the profile.
7. The method of any one of the previous embodiments, **characterised in that** the three-dimensional shell sat model is at least designed based on the two-dimensional profile, the additional parameters and a database with one or more, two-dimensional, transverse cross-sections of the seating surface of personalized shell seats.
8. The method of any one of the previous embodiments, **characterised in that** the element comprises elongated, rigid parts, extending over the width direction of the element.
9. The method of any one of the previous embodiment 8, **characterised in that** said rigid parts comprise plywood or multiply.
10. The method of any one of the previous embodiments 8 and 9, **characterised in that** the flexural rigidity of the element, associated with the flexure of the element according to the width direction, is situated between 0.2 N/mm² and 40 N/mm².
11. The method of any one of the previous embodiments, **characterised in that** the element can be bent elastically according to the longitudinal direction, with a maximum curvature of at least 0,025 mm⁻¹.
12. The method of the previous embodiment 11, **characterised in that** the element comprises one or more elongated, elastically deformable parts, extending over a part of or the complete longitudinal direction of the element.
13. The method of any one of the previous embodiments 11 and 12, **characterised in that** said, elastically deformable parts comprise spring steel.
14. The method of any one of the previous embodiments, **characterised in that** the seating device comprises a frame with one or more attachment points, in which the element is retained in the attachment points in a removable way and in which the position of the attachment points with respect to the frame can be set.
15. The method of any one of the previous embodiments, **characterised in that**, based on a digital impression of the modelled shell seat, one or more outer characteristics of the modelled shell seat are modified.
16. A computer-controlled program for designing a personalised shell seat for a subject, **characterised in that** the input of the program comprises a digital image of a seating device, in which the seating device is adjusted to the posture and/or body contours of the subject.
17. The computer-controlled program of the previous embodiment 16, **characterised in that** the input of the program comprises moreover one or more parameters, linked to anatomic dimensions of the subject, and a database, with one or more transverse cross-sections of the seat and/or back of subjects.
18. The computer-controlled program of any one of the previous embodiments 16 and 17, **characterised in that** the program validates at least a part of the input based on validation rules.
19. The computer-controlled program of any one of the previous embodiments 16 to 18, **characterised in that** the program generates a digital impression of the modelled shell seat.
20. The computer-controlled program of any one of the previous embodiments 16 to 19, characterised in that it is appropriate for application in the method of any one of the embodiments 1 to 15.
21. A personalised shell seat for a subject, characterised in that the shell seat is modelled based on a two-dimensional, sagittal cross-section of the seating surface of the seating device, adjusted to the subject that sits onto it.
22.The shell seat of the previous embodiment 21, characterised in that it is modular.
23.The shell seat of the previous embodiment 21, **characterised in that** it is monolithic.
24.The shell seat of any one of the previous embodiments 22 and 23, **characterised in that** it is modelled, using the method of any one of the embodiments 1 to 15.

### DETAILED DESCRIPTION OF THE FIGURES

In the following, the invention will be described by means of non-limiting examples and figures illustrating the invention, and not meant to be interpreted as limiting the scope of the invention.

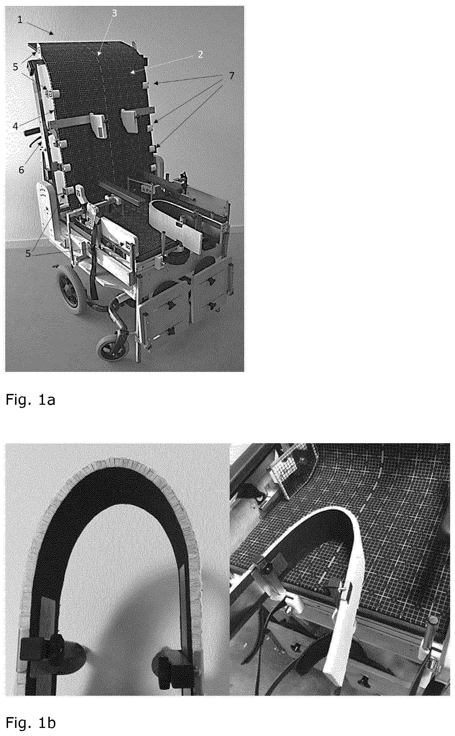

**Figure 1a** shows an embodiment of the seat device **1** in three-dimensional perspective, in which the seat device **1** is provided with a semi-flexible element **2.** The semi-flexible element **2** is a thin, rectangular, elongated mat. It has a structure so that it can be bent according to its longitudinal direction into a seating surface, in which the seating surface comprises a least a seat and a back. In its width direction, the element **2** is rigid. As a result, each parasagittal profile of the seating surface of the seating device **1** is the same, and equal to the sagittal profile **3** of the seating device **1.** The sagittal profile itself can thus be derived from the parasagittal profile at the side **4** of the element **2.** Therefore, the element **2** is at least at one side **4** provided with a colour shading bright-dark, that can be recognised on a picture by means of special software. The element **2** can be provided either at one or at both sides **4** with such colour shading. The shape and dimensions of this profile **3** can be further derived from the photograph by means of further software, after at least a perspective transformation. Thereto, reference points **5** are provided, that are associated with the frame **6** of the seating device **1** in a fixed way. It is about a type of fiduciary marks. Said reference points **5** are preferably situated in the same plane as the side **4** of the element **2.** Possibly, the seating device **1** comprises additional parts, either to increase the seating comfort, or to facilitate measurements. The semi-flexible element **2** is comprised in the frame **6** of the seating device **1** in a removeable way, by means of attachment points **7.** The element **2** can thus be replaced by another element **2**, with for example other characteristics as to the rigidity and flexibility. For example, the attachment points **7** are U-shaped holders, that can be slit over the element **2.** The position of the attachment points **7** with respect to the frame **6** can be changed by means of screws at the back of the seating device **1.** To further improve the adjustability, the frame **6** can be composed of two or more parts that can move with respect to each other, for example a back and a seating part.

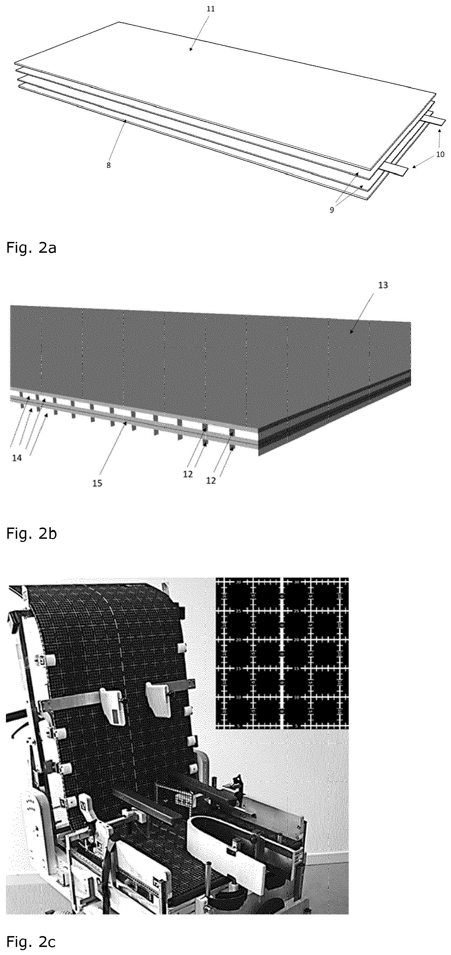

**Figure 2a** shows an exploded view of the semi-flexible element **2**, according to a possible embodiment. According to this embodiment, the element **2** is a layered structure. For its fabrication, one starts with a rigid base **8**, for example a plywood base. Thereto, a flexible material is glued, preferably an elastic sheet **9**, such as a neoprene sheet. Subsequently, a spring-steel strip iron **10** is glued thereto, extending over the length of the element. This can be one strip, or several, parallel strips. Thereto, again a neoprene sheet **9** is glued, with a rigid top sheet **11** on top of it. After drying the glue, parallel saw-cuts **12** are made both in the top sheet **11** and the base **8**, each time up to the neoprene sheet **9**, according to the width direction of the element **2.** The saw-cuts **12** in the lower and upper side are made at the same position in the element **2.** The result is that the element **2** is composed of elongated, rigid zones, oriented according to the width direction, interchanged with folding zones. Subsequently, another top layer **13** is glued on top of this element **2**, for the seating comfort of the subject that sits onto it. This top layer **13** is for example made of foam.

This is only one possible embodiment of the element. Neoprene can of course be changed by any other flexible sheet **9.** The top layer **13** can also be made of textile or leather. According to an alternative embodiment, the top layer comprises Veclro material, for indicating for example the sagittal line **3** on the element, or for attaching extra element such as leg supports. Furthermore, the base **8** and the top sheet **11** can be fabricated from another material than plywood, for example solid core. The element **2** should also not be rectangular. The element also does not need to have a layered structure: according to an alternative embodiment, the element **2** is composed of a rubber piece, into which a number of metal rods are integrated, extending over the width direction of the element **2.** The order of the layers can also be changed. However, with the plywood strips **14** at the lower and upper side, (possibly at the upper side, finished with a top layer), the rigidity of the plywood can be used maximally, as a resistance against flexure of the element **2** according to its width direction.

**Figure 2b** shows a semi-flexible element **2** in perspective, according to the same embodiment as described above. The element **2** takes in a thin, rectangular volume, with a length of 150 cm, a width of 60 cm and a thickness of 12 mm. The element **2** is composed of elongated, parallel, rigid zones, oriented according to the width direction, interchanged with folding zones. Thus, the element **2** is difficult to bend according to its width direction, but is however easy to bend according to its longitudinal direction. At at least one side **4**, the element **2** is provided with colour shadings. For example, this side is provided with brightly coloured lines or boxes along a dark-colour background. According to the present embodiment, the plywood strip **14** base, the neoprene/spring steel layer **15** and the foam top layer are dark-coloured at this side **4**, while the ends of the plywood strips **14** in the top layer are brightly coloured. As a result, the side of the element can be recognized on a photograph by means of automatic image recognition techniques.

**Figure 2c** shows an embodiment, in which the mat is provided with a print with specific matrix pattern, in which the pattern allows to take certain measures such as width and length of the patient in a simple way.

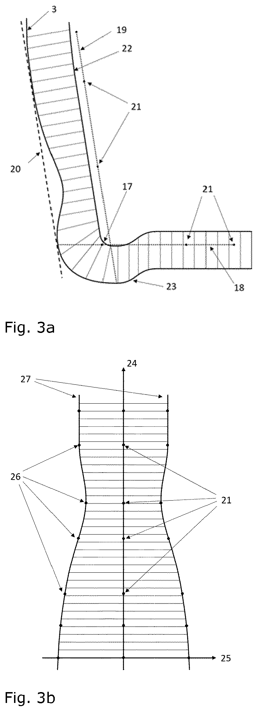

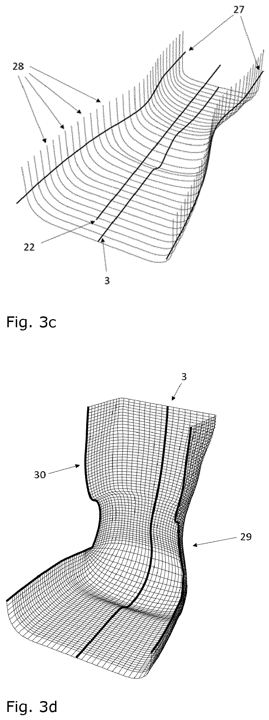

**Figures 3a****-d** show an embodiment of a part of the method, in which the seating surface of the shell seat **16** is modelled based on the sagittal profile **3**, a number of measurement points and a database with transverse cross-sections at the back and the seat of subjects. A first step is palpating the trochanter major **17**, so that its position can be localised. Preferably, this position in the seating device **1** is marked by means of a digitally detectable mark. The shape and dimensions of the sagittal profile **3** of the seating surface are, preferably together with the location of the trochanter major **17**, derived from the digital image. The image is preferably imported and processed by means of a tablet. The sagittal profile **3** and the trochanter major **17** are illustrated in 2D. At the back side of the sagittal profile **3**, a back tangent line **20** is constructed. Subsequently, an oblique coordinate system is drawn, with an x-axis **18** and a y-axis **19** that are parallel with the back tangent line **20.** The x-axis **18** essentially coincides with the thigh-bone of the subject, and starts from the lowest tangent of the sagittal profile **3** with the back tangent line **20.** The y-axis **19** is essentially oriented to the armpits of the subject, and starts from the deepest point of the sagittal profile **3.** For a number of sample points **21**, its location along the x-axis **18** (the longitudinal location) or the y-axis **19** (the height location) is measured. Amongst other things the knee length, the lordosis height, the waist height, the arm pit height and the shoulder height are measured. These points are also imported into the tablet, that shows this information in the 2D figure. From this coordinate system, a so-called sample line **22** is drawn. This sample line **22** is parallel to the y-axis **10** till the trochanter major **17**, then follows the curvature of the cuvet **23** and subsequently extends parallel to the x-axis **18.** The sample points **20** are projected perpendicularly to the sample line **22.** At these projected sample points, the width of the subject is measured, transverse to the 2D figure. These widths are imported into the tablet. A second 2D figure is drawn, with the arc length along the sample line **24** as vertical axis and with the body width **25** as the horizontal axis. Thereto, the sample points **21** are indicated, as well as the width at each sample point. These discrete width points **26** are interpolated by means of a continuous, interpolating width curve **27.** The graph is extended to 3D, by adding the folded-open, sagittal profile **3.** The data then comprise three curves in the horizontal space: the folded-open sagittal profile **3**, the left width curve **27** and the right width curve **27.** They are subsequently linked transversely with scaled, transverse cross-sections **28** on the back and seat of subjects (from a database). Said cross-sections **28** are scaled, so that they take into account the dimensions of the present subject, but they have a standard shape, taken from said database. This is sufficient in 70% of the cases. Subsequently, the folded-open 3D surface that is thus genereted, is folded up again. In this way, a three-dimensional model **29** for the seating surface of the shell seat **16** is made. Thereto, a trim line **30** is drawn, that expresses up to where the sides of the shell seat will be provided.

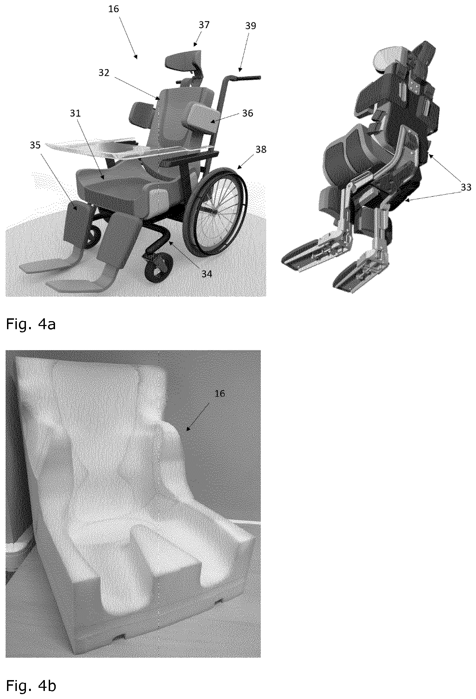

**Figure 4a** shows a modular shell seat **16** according to an embodiment of the invention. It is composed of milled pieces (for example the seat **31**, the back support **32**, the arm pit supports **36**...) that are coated with (synthetic) leather and that are attached to solid core panels **33** (for example a base plate, back plate, ...) that are mounted to each other and/or to a frame **34.** Different parts, such as the feet supports **35** and the head rest **37** can be adjusted or omitted. Preferably, these parts are available as prefabricated parts in three standard sizes: small, medium, large. This, in an effort to make the fabrication cheaper, because these parts do not have to be personalised anyway as to its shape. Preferably, the different parts of the shell seat **16** can be adjusted after its fabrication. The back support **32** of the finished shell seat **16** can for example be adjusted by means of an built-in rotation system with wheels along curved rails. As a result, a subject can take different positions, which offers extra user comfort. Moreover, the position of an articulating point at the trochanter major **17** ensures that the back stays positioned correctly on the back support **32** in all possible positions. The computer program on the tablet generates and shows an impression of the final shell seat **16.** Based on this impression, the outer characteristics can be observed and adjusted/personalised. For example, a back plate at the back can be provided with colours or a logo. A particular stitching profile can for example be provided in the cushions. The prefabricated parts can for example be finished by means of water transfer printing. Also, stitches with text can be provided on the coating of the foam, that is made of textile and/or leather. According to a preferred embodiment of the invention, it is realized as a wheel chair, provided with wheels **38** and push bars **39.** According to another preferred embodiment, the shell seat **16** is provided with fixation means, at the back side, the leg side or a combination of both.

**Figure 4b** shows an embodiment of a shell seat **16**, that has been milled monolithically out of one block of foam. Preferably, a polyurethane foam block is used therefore. The advantage is the simple fabrication process and thus the low cost and fast delivery. More preferably, the element is covered with textile and/or leather.

It will be understood that the present invention is not limited to the embodiments described above and that some adjustments or changes can be added to the described examples without changing the scope of the enclosed claims.

The enumerated elements on the figures are:
1. Seating device
2. Semi-flexible element
3. Sagittal profile
4. Side element
5. Reference points
6. Frame
7. Attachment points
8. Stiff base (plywood)
9. Elastic sheet (neoprene)
10. Spring-steel strip iron
11. Stiff upper plate (plywood)
12. Parallel saw-cuts
13. Upper layer
14. Plywood strips
15. Neoprene/spring-steel layer
16. Shell seat
17. Trochanter major
18. X-axis
19. Y-axis
20. Back tangent line
21. Sample points
22. Sample line
23. Cuvet
24. Arc length along the sample line
25. Body width
26. Width points
27. Interpolating width curve
28. Transverse cross-sections
29.Three-dimensional shell seat model
30.Trim line
31. Seat
32. Back support
33. Solid core panels
34. Frame
35. Foot supports
36. Arm pit supports
37. Head rest
38. Wheels
39. Push bars

## Claims

1. A method for designing a personalized shell seat **16** for a subject, the method comprising obtaining a two-dimensional sagittal profile **3** of the seating surface of a seating device **1**, in which the shape of the seating surface is adapted to the posture and/or body contours of a subject seating onto the seating device, and the computer-controlled design of a three-dimensional shell seat model, at least based on said obtained two-dimensional profile **3.**

2. The method of the previous claim 1, **characterised in that** the seating surface of the seating device **1** is realized by means of a thin, semi-flexible, rectangular element **2**, that is rigid in its width direction and flexible in its longitudinal direction, in which the element **2** is bent according to the longitudinal direction to a conventional seating surface, adapted to the posture and/or the body contours of the subject.

3. The method of any one of the previous claims , **characterised in that** the profile **3** is generated by means of digitally detectable reference points **5** provided at the seating device **1.**

4. The method of the previous claim 3, **characterised in that** a digital image of the seating device **1** that has been adjusted to the subject provided with reference points **5** is obtained, and is entered in a computer-controlled program, after which the profile **3** is generated by said program.

5. The method of one of the previous claims, **characterised in that** additional parameters are entered in the computer-controlled program, in which the parameters are linked to anatomic dimensions of the subject.

6. The method of the previous claim 5, **characterised in that** at least a part of said parameters is linked to the profile **3.**

7. The method of any one of the previous claims, **characterised in that** the three-dimensional shell sat model is at least designed based on the two-dimensional profile **3**, the additional parameters and a database with one or more, two-dimensional, transverse cross-sections of the seating surface of personalized shell seats **16.**

8. The method of any one of the previous claims, **characterised in that** the element **2** comprises elongated, rigid parts **14**, extending over the width direction of the element **2.**

9. The method of any one of the previous claims 8 and 9, **characterised in that** the flexural rigidity of the element **2**, associated with the flexure of the element **2** according to the width direction, is situated between 0,2 N/mm² and 40 N/mm².

10. The method of any one of the previous claims, **characterised in that** the element **2** can be bent elastically according to the longitudinal direction, with a maximum curvature of at least 0,025 mm⁻¹.

11. The method of any one of the previous claims, **characterised in that** the seating device **1** comprises a frame **6** with one or more attachment points **7**, in which the element **2** is retained in the attachment points **7** in a removable way and in which the position of the attachment points **7** with respect to the frame **6** can be set.

12. A computer-controlled program for designing a personalised shell seat **16** for a subject, **characterised in that** the input of the program comprises a digital image of a seating device **1**, in which the seating device **1** is adjusted to the posture and/or body contours of the subject.

13. The computer-controlled program of the previous claim 12, **characterised in that** the input of the program comprises moreover one or more parameters, linked to anatomic dimensions of the subject, and a database, with one or more transverse cross-sections **28** of the seat and/or back of subjects.

14. The computer-controlled program of any one of the previous claims 12 and 13, **characterised in that** the program generates a digital impression of the modelled shell seat **16.**

15. A personalised shell seat **16** for a subject, **characterised in that** the shell seat **16** is modelled based on a two-dimensional, sagittal cross-section **3** of the seating surface of the seating device **1**, adjusted to the subject that sits onto it.
